# EUROPÄISCHE PATENTSCHRIFT

(11) **EP 2 805 345 B1**
(45) Veröffentlichungstag und Bekanntmachung des Hinweises auf die Patenterteilung: **28.12.2016**
(21) Anmeldenummer: 13700638.3
(22) Anmeldetag: 09.01.2013
(51) Int. Cl.: H01J 37/32, H05H 1/44

(54) **VORRICHTUNG UND VERFAHREN ZUR PLASMABEHANDLUNG VON OBERFLÄCHEN**
DEVICE AND METHOD FOR PLASMA TREATMENT OF SURFACES
DISPOSITIF ET PROCEDE DE TRAITEMENT DE PLASMA DE SURFACES

(30) Priorität: 17.01.2012 DE 102012000689; 08.08.2012 DE 102012107282
(43) Veröffentlichungstag der Anmeldung: 26.11.2014
(73) Patentinhaber: Maschinenfabrik Reinhausen GmbH, 93059 Regensburg (DE)
(72) Erfinder: NETTESHEIM, Stefan, 12205 Berlin (DE); FORSTER, Klaus, 93077 Bad Abbach (DE); KORZEC, Dariusz, 93173 Wenzenbach (DE)
(74) Vertreter: Reichert, Werner Franz
(86) Internationale Anmeldenummer: PCT/EP2013/050293
(87) Internationale Veröffentlichungsnummer: WO 2013/107675

(56) Entgegenhaltungen:
- EP-A1- 1 936 656
- US-A1- 2006 219 361
- US-A1- 2008 295 872
- US-A1- 2009 156 013
- US-B1- 6 167 835

## Beschreibung

Die Erfindung betrifft ein Verfahren und eine Vorrichtung zur Plasmabehandlung von Oberflächen. Insbesondere eignet sich die Erfindung zur schonenden Plasmabehandlung von thermisch labilen Oberflächen. Die Plasmabehandlung kann beispielsweise eine Aktivierung, Reinigung, Entfettung oder Reduktion von Oberflächen sein. Dazu erzeugt mindestens eine Plasmaquelle ein Plasma und das Plasma wird einem abgeschlossenen Raum, mit denen die mindestens eine Plasmaquelle in fluider Verbindung steht, zugeführt. Werkstücke, deren Oberflächen behandelt werden sollen, werden in dem abgeschlossenen Raum angeordnet oder das Werkstück selbst ist Teil des abgeschlossenen Raums. Eine Absaugung stellt zwischen dem abgeschlossenen Raum und der mindestens einen Plasmaquelle eine Druckdifferenz ein.

Die Anwendung eines ins Vakuum expandierenden Lichtbogens zur großflächigen Plasmabehandlung ist seit Langem bekannt. Eine thermische Behandlung von Werkstücken wurde in der US-Patentschrift US 3,010,009 veröffentlicht.

Ein Verfahren zur Beschichtung von Werkstückoberflächen mittels eines Niederdruckplasmas wird in der US-Patentschrift US 3,839,618 offenbart.

Die US-Patentschrift US 6,872,428 B2 thematisiert das Problem der großflächigen bzw. doppelseitigen Plasmabehandlung von Werkstücken und sieht eine Lösung des Problems durch einen Einsatz einer Vielzahl von Lichtbogen-Plasmajets vor.

Die US 5,853,815 ist eine Vorrichtung zur Beschichtung eines großflächigen Substrats mithilfe eines aus einem Lichtbogen expandierendem Niederdruckplasmas, dem ein Pulver zugeführt wird. Durch eine Kippbewegung eines Plasmaerzeugers können große Flächen beschichtet werden.

In der internationalen Patentanmeldung WO 2010/089175 A1 ist ein Vorrichtung und ein Verfahren zur Plasmabehandlung offenbart, wobei ein Führungsrohr zum Schutz eines Plasmastrahls vor einer Kontamination mit einem degenerierten Pulver eines Beschichtungsprozesses vorgesehen ist.

Zum Schutz eines Plasmastrahls vor Luftverwirbelungen in einer Umgebung eines Plasmabrenners sieht die internationale Patentanmeldung WO 2011/094224 A1 eine Abschirmung aus Lochblech vor.

Die unveröffentlichte internationale Patentanmeldung PCT/EP2012/060497 offenbart eine Vorrichtung und ein Verfahren zur Plasmabehandlung von Hohlkörpern. Ein Hohlkörper wird hierzu in eine Druckkammer eingebracht, in der mithilfe einer Absaugvorrichtung eine Druckdifferenz gegenüber einer Plasmaquelle erzeugt werden kann. Die Plasmaquelle befindet sich außerhalb der Druckkammer. Durch eine Regeleinheit wird eine Energiequelle derart geregelt, dass ein pulsierendes Plasma entsteht. Eine Plasmaführung mit je einem Auslass für einen Zustrom von Plasma ragt in einen zu behandelnden Hohlkörper.

Die unveröffentlichte internationale Patentanmeldung PCT/EP2012/060494 offenbart eine Vorrichtung und ein Verfahren zur Plasmabehandlung von Oberflächen. Ein Werkstück wird hierzu in eine Druckkammer eingebracht, in der mithilfe einer Pumpe ein gegenüber einer Plasmaquelle geringerer Druck erzeugt werden kann. Die Plasmaquelle befindet sich außerhalb der Druckkammer. Durch eine Plasmadosiereinheit kann ein Zustrom eines Plasmastrahls in die Druckkammer und auf das Werkstück eingestellt werden. Weiterhin kann ein moduliertes Plasma erzeugt werden.

In der deutschen Offenlegungsschrift DE 102 03 543 A1 ist eine Vorrichtung zur Erzeugung eines Atmosphären-Glimmentladungs-Plasmas offenbart, die bei Einsatz in Vorrichtungen zur Plasmabehandlung eine besonders homogene Bearbeitung eines Substrats dadurch erreicht werden soll, dass ein Strömungsweg eines durch mehrere Gaszufuhrleitungen einer Plasmaquelle zugeführte Gas im Wesentlichen gleich gehalten wird.

Die DE 195 32 412 A1 offenbart eine Vorrichtung und ein Verfahren zur Oberflächenbehandlung von Werkstückoberflächen. Eine Behandlung von Werkstücken mit einem relativ komplizierten Relief soll dadurch ermöglicht werden, dass ein gebündelter Strahl eines reaktiven Mediums durch Plasmaentladung unter Zufuhr eines Arbeitsgases erzeugt und eine zu behandelnde Oberfläche dem erzeugten Strahl ausgesetzt wird. Eine gleichmäßige Vorbehandlung von flächig ausgedehnten Werkstücken soll durch mehrere in einer Reihe oder in mehreren Reihen auf Lücke angeordnete und in einen gemeinsamen Arbeitskopf integrierte Strahlgeneratoren erreicht werden.

Die internationale Patentanmeldung WO 2005/099320 A2 offenbart eine Vorrichtung und ein Verfahren zum Erzeugen eines Niederdruckplasmastrahls aus einem Plasmastrahl höheren Drucks. Dieser wird in einer Plasmaquelle erzeugt, die mit einem Prozessgas und mit Energie aus einem hochfrequenten Hochspannungsfeld gespeist wird. Die Plasmaquelle ist mit einer Niederdruckkammer, in der Werkstück angeordnet wird, verbunden, und ragt zumindest teilweise in sie hinein. In der Niederdruckkammer wird von einer Pumpe gegenüber der Plasmaquelle ein Unterdruck erzeugt. unterschiedlicher Konzentration überlagert werden. Eine Vergrößerung der Homogenität des Plasmaniederschlags auf der Werkstückoberfläche soll gemäß einem Ausführungsbeispiel durch zwei Plasmaquellen erreicht werden, die in einander gegenüberliegenden Seitenwänden der Niederdruckkammer angeordnet und aufeinander zu gerichtet sind.

US 2006/219361 A1, US 6,167,835 B1, EP 1 936 656 A1, US 2009/156013 A1, US 2008/0295872 A1 offenbaren Vorrichtungen und Verfahren zur Plasmabehandlung von Oberflächen von mindestens einem Werkstück.

Durch keine der aus dem Stand der Technik bekannten Vorrichtungen und Verfahren ist es möglich, Werkstücke beliebiger Form aus beliebigen Werkstoffen einer Plasmabehandlung zu unterziehen, weil entweder eine zu hohe thermische oder mechanische Belastung auf die Werkstücke einwirkt oder die Oberflächen aufgrund ihres Ausmaßes oder ihrer Kontur einer Plasmabehandlung nicht vollständig, insbesondere nicht in einem Arbeitsgang zugänglich sind. Die im Stand der Technik bekannten Ansätze zur Lösung dieser Probleme gehen zu Lasten der Einfachheit und Kostengünstigkeit der beschriebenen Vorrichtungen und Verfahren.

Der Erfindung liegt die Aufgabe zugrunde, eine Vorrichtung zu schaffen, die einfach aufgebaut ist und mit der eine schonende, gleichmäßige und gleichzeitige Plasmabehandlung von mehreren Oberflächen beliebig geformter Werkstücke ermöglicht wird.

Diese Aufgabe wird gelöst durch eine Vorrichtung, die die Merkmale des Anspruchs 1 umfasst.

Weiterhin ist es die Aufgabe der Erfindung, ein Verfahren zu entwickeln, mit dem eine schonende, gleichmäßige und gleichzeitige Plasmabehandlung von mehreren Oberflächen beliebig geformter durchgeführt werden kann.

Diese Aufgabe wird gelöst durch ein Verfahren, das die Merkmale des Anspruchs 11 umfasst.

Die erfindungsgemäße Vorrichtung zur Plasmabehandlung von Oberflächen von mindestens einem Werkstück umfasst mindestens eine Plasmaquelle mit einer Energiequelle zur Erzeugung eines Plasmas, einen abgeschlossenen Raum, der mit der mindestens einen Plasmaquelle in fluider Verbindung steht und mindestens eine Absaugung zur Einstellung einer Druckdifferenz zwischen der mindestens einen Plasmaquelle und dem abgeschlossenen Raum.

Vorzugsweise arbeitet die Plasmaquelle unter Atmosphärendruck oder Überdruck, im abgeschlossenen Raum herrschen zumindest Teilvakuumbedingungen und das erzeugte Plasma ist ein Atmosphärendruckplasma, z. B. ein ausgeblasener Lichtbogen. Jedoch ist die Plasmaquelle nicht auf die Erzeugung eines solchen Plasmas beschränkt und die Druckverhältnisse in der Plasmaquelle und dem abgeschlossenen Raum sind frei einstellbar. Die Einstellung der Druckdifferenzen zwischen dem abgeschlossenen Raum und der mindestens einen Plasmaquelle kann nicht nur durch die Absaugung, sondern auch durch eine Öffnung, mit der der abgeschlossene Raum mit jeweils einer Plasmaquelle in fluider Verbindung steht, beeinflusst bzw. gesteuert werden. Die mindestens eine Öffnung ist als Düse oder Ventil ausgebildet, um neben den Druckverhältnissen in der Plasmaquelle und dem abgeschlossenen Raum auch die Formung des jeweiligen Plasmastrahls zu beeinflussen. Ein weiterer Parameter zur Einstellung der Druckdifferenzen zwischen dem abgeschlossenen Raum und der mindestens einen Plasmaquelle ist die Ausgestaltung einer Gaszuführung, durch welche der Plasmaquelle Gas zur Erzeugung des Plasmas zugeführt wird. Wird z. B. das Gas durch die Gaszuführung mit einem gegenüber dem abgeschlossenen Raum erhöhten Druck eingebracht, entsteht ein Überdruckplasma. Dieser Überdruck kann dadurch gesteigert werden, dass in dem abgeschlossenen Raum ein Vakuum erzeugt wird. Die mindestens eine Plasmaquelle kann gegenüber dem abgeschlossenen Raum beliebig orientiert werden, auch wenn in den beschriebenen Ausführungsformen der erfindungsgemäßen Vorrichtung vertikal angeordnete Plasmaquellen gezeigt werden.

Erfindungsgemäß ist je einer der Plasmaquellen mindestens ein Plasmaverteilungselement, das eine Vielzahl von Plasmaaustrittsöffnungen aufweist, in Strömungsrichtung nachgeordnet.

Durch das mindestens eine Plasmaverteilungselement ist das bereits erzeugte Plasma aufteilbar, so dass mehrere Plasmastrahlen aus einer Plasmaquelle erzeugbar sind. Es ist also keine Energie- und Gaszufuhr in unmittelbarer Umgebung eines Plasmastrahls zur Erzeugung des Plasmastrahls notwendig und mehrere Plasmastrahlen sind unabhängig von der Lage der mindestens einen Plasmaquelle mindestens einer Oberfläche eines Werkstücks zeitgleich zuführbar. Ferner sind durch die Tatsache, dass das Plasma aus einer Plasmaquelle in mehrere Plasmastrahlen aufgeteilt wird, bezogen auf die Leistung von Plasmaquelle, Energiequelle, Gaszufuhr und Absaugung, größere Oberflächen behandelbar. Das mindestens eine Plasmaverteilungselement kann aus mehreren Hohlkörpern aufgebaut sein, z. B. aus zylindrischen Rohrstücken, analog zu Verrohrungen, die zum Aufbau von Gas- oder Wasserleitungssystemen verwendet werden können. Es können prinzipiell sämtliche Werkstoffe verwendet werden, die sich hinsichtlich der mechanischen und thermischen Festigkeit eignen und die Eigenschaften des Plasmas gezielt positiv oder zumindest nicht negativ oder beeinflussen.

Das mindestens eine Plasmaverteilungselement ist derart ausgebildet, dass ein Normalenvektor einer Ebene einer jeden Plasmaaustrittsöffnung auf eine zu behandelnde Oberfläche des mindestens einen Werkstücks gerichtet ist. Der Normalenvektor der Ebene der jeweiligen Plasmaaustrittsöffnung definiert eine Richtung eines Plasmastrahls.

Das mindestens eine Plasmaverteilungselement kann der Form des zu behandelnden Werkstücks und/oder der gewünschten Behandlungsart bzw. - intensität von Werkstücken angepasst werden. Die Richtung der Plasmastrahlen beruht nicht, wie aus dem Stand der Technik bekannt, ausschließlich auf dem Prinzip einer Plasmaexpansion aufgrund einer Druckdifferenz zwischen Plasmastrahl und einem Raum, in dem sich das Werkstück befindet. Die Plasmastrahlen werden direkt gerichtet mindestens einer Werkstückoberfläche zugeführt. Die mehreren durch eine Plasmaquelle erzeugten Plasmastrahlen können hinsichtlich Intensität, Form, Volumen, Richtung, Öffnungswinkel, Abstand zur Werkstückoberfläche gezielt gesteuert werden. Innerhalb des mindestens einen Plasmaverteilungselements können die Plasmastrahlen bezüglich der im vorangegangen Satz genannten Parameter identisch oder unterschiedlich sein.

Somit ist sowohl eine homogene Behandlung mehrerer Oberflächen, als auch eine gezielt differenzierte Behandlung verschiedener Oberflächen eines Werkstücks oder verschiedener Bereichen einer Oberfläche eines Werkstücks ermöglicht. Mögliche Parameter zur gezielten Beeinflussung von Intensität, Form, Richtung, Öffnungswinkel, Volumen, Abstand zur Werkstückoberfläche der Plasmastrahlen sind unter anderem die Länge des Strömungsweges, die das Plasma bis zur jeweiligen Plasmaaustrittsöffnung zurückzulegen hat, der Querschnitt (Querschnittsform, Querschnittsfläche) und/oder Querschnittsverlauf (Änderung der Querschnittsform oder der Querschnittsfläche entlang des Strömungswegs) der einzelnen Plasmaführungen im Plasmaverteilungselement und/oder die Ausgestaltung der Plasmaaustrittsöffnungen. In den Plasmaaustrittsöffnungen sind Düsen vorgesehen werden, mit denen der Plasmastrahl geformt, z. B. aufgeweitet wird. Weiterhin ist es denkbar, Ventile in den Plasmaaustrittsöffnungen vorzusehen, um den Volumenstrom oder den Druck einzelner Plasmastrahlen unabhängig voneinander zeitlich zu steuern. Durch eine Ausgestaltung der Oberflächenbeschaffenheit (Oberflächenrauheit, Oberflächenbehandlungen, z. B. Beschichtungen) der Strömungsflächen des Plasmaverteilungselements kann das Plasma ebenfalls beeinflusst werden. Im Wesentlichen ist das mindestens eine Plasmaverteilungselement ein strömungstechnisches Verteilungssystem. Demnach sind zur Ausgestaltung des mindestens einen Plasmaverteilungselements und Beeinflussung der Plasmastrahlen sämtliche Parameter und Gesetzmäßigkeiten der Strömungslehre, die für die Auslegung allgemeiner strömungstechnischer Systeme, wie etwa Gas- oder Wasserleitungssystemen berücksichtigt werden können, heranziehbar.

In einer vorteilhaften Ausgestaltung der erfindungsgemäßen Vorrichtung sind die Plasmaaustrittsöffnungen des mindestens einen Plasmaverteilungselements zur Plasmabehandlung eines im Wesentlichen quaderförmigen Werkstücks ungleichmäßig entlang einer Außenkontur des Werkstücks angeordnet.

Gemäß einer Ausführungsform der erfindungsgemäßen Vorrichtung ist das mindestens eine Plasmaverteilungselement als fraktales Plasmaverteilungselement ausgebildet.

Als fraktal wird im Allgemeinen eine Geometrie bezeichnet, wobei eine Vergrößerung eines Ausschnitts der Geometrie prinzipiell ihrer Gesamtstruktur entspricht. Ein Beispiel hierfür ist die mehrfach verzweigte Struktur biologischer Fluidkanäle. Unter einem fraktalen Plasmaverteilungselement der gegenwärtigen Erfindung wird ein Plasmaverteilungselement verstanden, das derart ausgestaltet ist, dass das Plasma entlang der Strömungsrichtung zu den Plasmaaustrittsöffnungen so aufgeteilt wird, dass mehrere identische Plasmastrahlen entstehen. Die identischen Teilströme bzw. die identischen Plasmastrahlen werden vorzugsweise dadurch erreicht, dass der vom Plasma zurückgelegte Weg von der Plasmaquelle bis hin zu den Plasmaaustrittsöffnungen gleich lang ist. Dies hat zur Folge, dass mehrere hinsichtlich sämtlicher Parameter identische Plasmastrahlen aus einer Plasmaquelle generierbar und mindestens einer Oberfläche mindestens eines Werkstücks zuführbar sind. Somit ist eine besonders homogene Behandlung einer Oberfläche eines Werkstücks ermöglicht. Gleiche Strömungswege zwischen Plasmaquelle und Plasmaaustrittsöffnungen garantieren allerdings unter Umständen keine homogene Plasmaverteilung. Einige weitere Faktoren wie die Querschnittsflächen bzw. die Änderungen der Querschnittsflächen entlang des Strömungswegs oder die Verwirbelung des Plasmas bei der Plasmaleitungstrennung spielen ebenfalls eine wichtige Rolle für die homogene Plasmaverteilung. An dieser Stelle wird nochmals auf sämtliche bekannte Parameter und Gesetzmäßigkeiten der Strömungslehre, verwiesen. Derartige Faktoren können bei der Ausgestaltung des mindestens einen Plasmaverteilungselements berücksichtigt werden, so dass durch das fraktale Plasmaverteilungselement eine gleichmäßige und gleichförmige Plasmaverteilung bei gleichzeitiger Minimierung der notwendigen Druckdifferenz zwischen Plasmaquelle und dem abgeschlossenen Raum sichergestellt ist. Mit dem fraktalen Plasmaverteilungselement sind unter anderem auch rechteckige oder hexagonale Plasmastrahlen-Matrizen realisierbar.

Zur Plasmabehandlung eines flächigen Werkstücks kann die erfindungsgemäße Vorrichtung ein Plasmaverteilungselement vorsehen, das derart ausgestaltet ist, dass Plasmaaustrittsöffnungen einer Oberseite und einer Unterseite des flächigen Werkstücks gegenüberliegen.

Als flächiges Werkstück wird ein Körper verstanden, der eine betragsmäßig größere Breite als Höhe aufweist. Anwendungsbezogene Beispiele flächiger Werkstücke sind Leiterplatten, insbesondere doppelseitige elektronische Platinen, Folien, Platten, Textilbahnen oder Bleche. Die Längsausdehnung der Werkstücke ist nicht begrenzt. Es können auch endlose Werkstücke wie Folienbahnen mit der erfindungsgemäßen Vorrichtung behandelt werden. Dazu kann z. B. ein Druckschleusensystem vorgesehen werden, bei dem der abgeschlossene Raum mit einer vorgeordneten Druckschleuse und einer nachgeordneten Druckschleuse verbunden ist, um Werkstücke mittels eines Bewegungsmittels in den abgeschlossenen Raum einzubringen und auszubringen. Wichtig ist hierbei, das Schleusensystem derart auszugestalten, dass die Druckdifferenz zwischen der Plasmaquelle und dem abgeschlossenen Raum aufrechterhaltbar ist.

Weiterhin kann der abgeschlossene Raum an gegenüberliegenden Begrenzungen mit jeweils mindestens einer Plasmaquelle versehen sein, denen jeweils ein Plasmaverteilungselement zugeordnet ist, so dass die Plasmaaustrittsöffnungen eines jeden Plasmaverteilungselements der Oberseite und der Unterseite des flächigen Werkstücks gegenüberliegen.

Es können sowohl identische als auch unterschiedliche Plasmaquellen und/oder Plasmaverteilungselemente angeordnet sein. Jeweils eine Plasmaquelle kann aus einer eigens ihr zugeordneten Gaszuführung und einer eigens ihr zugeordneten Energiequelle versorgt werden. Zudem ist es möglich, die Plasmaquellen mit einer gemeinsamen Gaszuführung und/oder Energiequelle zu versorgen. Zwischen den jeweiligen Plasmaquellen und dem abgeschlossenen Raum sind gleiche und unterschiedliche Druckdifferenzen einstellbar. So kann bei der Behandlung eines flächigen Körpers beispielsweise ein erstes Plasma, das der Oberseite des flächigen Körpers zugeführt wird, einen höheren Druck aufweisen, als ein zweites Plasma, das der Unterseite zugeführt wird. Die Öffnungen des abgeschlossenen Raums, durch welche der abgeschlossene Raum mit den Plasmaquellen in fluider Verbindung steht, können je nach Plasmaquelle gleich und unterschiedlich ausgebildet sein. Analog zu allen anderen Ausführungsformen sind die Öffnungen als Düsen oder Ventile ausgebildet. Der Abstand zwischen den Plasmaaustrittsöffnungen des mindestens einen Plasmaverteilungselements, das der Oberseite des Werkstücks gegenüberliegt und der Oberseite des Werkstücks, kann gleich, größer oder kleiner als der Abstand zwischen den Plasmaaustrittsöffnungen des mindestens einen Plasmaverteilungselements, das der Unterseite des Werkstücks gegenüberliegt und der Unterseite des Werkstücks sein. Durch ein Bewegungsmittel können die Abstände der Plasmaaustrittsöffnungen zu der mindestens einen Oberfläche des Werkstücks auch im zeitlichen Verlauf veränderbar sein. Es ist möglich, die Ober- und Unterseite des flächigen Werkstücks einer identischen Plasmabehandlung zu unterziehen oder die Ober- und Unterseite des flächigen Werkstücks mit unterschiedlichen Plasmastrahlen zu beaufschlagen. Auch hier ist eine homogene Behandlung mehrerer Oberflächen oder eine gezielt differenzierte Behandlung verschiedener Oberflächen eines Werkstücks oder verschiedener Bereiche einer Oberfläche eines Werkstücks ermöglicht. Auch bei den beschriebenen Ausführungsformen zur Behandlung flächiger Werkstücke können die Plasmaverteilungselemente als fraktale Plasmaverteilungselemente ausgebildet sein.

In einer weiteren vorteilhaften Ausgestaltung der erfindungsgemäßen Vorrichtung können die Plasmaaustrittsöffnungen des mindestens einen Plasmaverteilungselements homogen um einen Umfang der zu behandelnden Oberfläche des Werkstücks verteilt sein.

Eine solche Ausgestaltung ist besonders zur Behandlung von Rundkörpern geeignet. Diese können einen beliebig geformten Umfang aufweisen. Neben kreisförmigen, ovalen oder elliptischen Körpern können also auch Körper mit komplexer, nicht achsensymmetrischer Kontur behandelt werden. Die Plasmaaustrittsöffnungen können gemäß der zu behandelnden Oberfläche so verteilt sein, dass die Plasmastrahlen den Umfang des Werkstücks gleichmäßig erfassen und so eine homogene Behandlung von Fasern, Faserbündeln, Kabeln, Rohre, Stangen, Drähten und ähnlichen Werkstücken ermöglicht ist. Es sei jedoch an dieser Stelle erneut darauf verwiesen, dass mit der erfindungsgemäßen Vorrichtung auch eine gezielt differenzierte Behandlung verschiedener Oberflächen eines Werkstücks oder verschiedener Bereichen einer Oberfläche eines Werkstücks durchführbar ist. Besonders vorteilhaft ist in dieser Ausführungsform die Verwendung eines oben beschriebenen Schleusensystems, so dass eine durchlaufende Behandlung von Werkstücken ohne Begrenzung derer länglichen Ausdehnung erreicht werden kann.

Gemäß einer Ausführungsform der erfindungsgemäßen Vorrichtung ist das mindestens eine Plasmaverteilungselement als Hohlkörper ausgebildet und die Plasmaaustrittsöffnungen sind homogen über eine Mantelfläche des mindestens einen Plasmaverteilungselements verteilt.

Gemäß dieser Ausführungsform ist eine Behandlung von mindestens einer Innenfläche von mindestens einem Werkstück erreichbar. Das mindestens eine Plasmaverteilungselement wird innerhalb des Werkstücks angeordnet und die Plasmaaustrittsöffnungen des mindestens einen Plasmaverteilungselements werden in Bezug auf die Innenfläche des Werkstücks angeordnet.

Die erfindungsgemäße Vorrichtung eignet sich zur Verwendung für jegliche Plasmabehandlungen von Oberflächen. Anwendungsbeispiele sind die Aktivierung, Reinigung, z. B. einer Innenreinigung von Rohren vor einer Schutzbeschichtung, Entfettung, Reduktion, z. B. einer Reduktion von Oxiden auf Metallkontakten einer doppelseitigen Leiterplatte, z. B. mit einem wasserstoffhaltigen Plasma, ausgehend von einem Formiergas oder einer Wasserstoff-Argon-Gasmischung oder eine Oxidation, z. B. mit einem sauerstoffhaltigen Plasma, ausgehend aus einer Luft-/Argon-Sauerstoffmischung.

Bei einer besonders vorteilhaften Ausgestaltung der erfindungsgemäßen Vorrichtung ist der abgeschlossene Raum durch das als Hohlkörper ausgebildete Werkstück selbst, einen Versorgungsflansch und einen Absaugflansch definiert. Dabei kann vorgesehen werden, dass durch den Versorgungsflansch mindestens eine Versorgungsleitung in den abgeschlossenen Raum ragt, an deren freien Ende die mindestens eine Plasmaquelle und das mindestens eine Plasmaverteilungselement sitzt, wobei der abgeschlossene Raum über einen Absaugflansch mit der Absaugung in fluider Verbindung steht. Dabei können die Plasmaaustrittsöffnungen des Plasmaverteilungselements homogen in Bezug auf eine Innenfläche des als Hohlkörper ausgebildeten Werkstücks verteilt sein.

Durch diese Anordnung entfällt die Prozesskammer, wodurch ein besonders einfacher, kompakter und kostengünstiger Aufbau der erfindungsgemäßen Vorrichtung bereitgestellt werden kann. Betrachtet man diese Ausführungsform analog zu den vorher beschriebenen Ausführungsformen, werden hier also die Innenflächen des abgeschlossenen Raums behandelt. Der Versorgungsflansch und der Absaugflansch werden auf das zu behandelnde Werkstück aufgebracht, um so die Druckdifferenz zwischen Plasmaquelle und dem abgeschlossenen Raum aufrecht zu erhalten. Dichtelemente können als separate Bauteile vorgesehen oder in den Versorgungsflansch und den Absaugflansch eingearbeitet sein.

Bei allen Ausführungsformen der erfindungsgemäßen Vorrichtung kann die Energiequelle eine gepulste Gleichstromquelle sein, so dass ein pulsierendes Plasma erzeugt werden kann.

Die Plasmaquelle wird erfindungsgemäß aus einer Energiequelle mit Energie gespeist. Durch ein Pulsen der zugeführten Energie bzw. der zugeführten Leistung kann ein pulsierendes Plasma erzeug werden. Insbesondere können die Strompulse Gleichstrompulse mit festen oder variablen Werten für Pulsdauer, Pulsintervall und/oder Betrag des Stroms sein. Durch ein pulsierendes Plasma kann eine mittlere Enthalpie der Plasmastrahlen herabgesetzt werden und so eine Wärmeleistung, eine thermische und/oder elektrostatische Belastung durch das Plasma auf das Werkstück eingestellt, insbesondere reduziert werden. Ferner ergibt sich gegenüber der Verwendung eines kontinuierlichen oder statischen Plasmas der Vorteil, dass der mittlere Druck in dem abgeschlossenen Raum wesentlich niedriger sein kann. Dadurch ist eine Behandlung von sowohl thermisch als auch mechanisch labilen Werkstücken wie Kunststofffolien, Biomaterialien, Fasergeweben, Zellstoffen, dünnen Metallfolien oder Kunststoffflaschen durchführbar. Es sei darauf hingewiesen, dass die gepulste Gleichstromquelle in der Beschreibung der gegenwärtigen Erfindung sowohl als Stromquelle, also als eine Energiequelle, bei der ein Strom als Führungsgröße dient, als auch als Spannungsquelle, also eine Energiequelle, bei der eine Spannung als Führungsgröße dient, verstanden werden soll. Es kann sich also bei der Energiequelle auch um eine gepulste Gleichspannungsquelle handeln. Auch wenn in der Beschreibung der Erfindung und in den beigefügten Figuren im Wesentlichen Bezug auf elektrische Energiequellen genommen wird, sei erwähnt, dass die Energie zur Erzeugung des Plasmas auch in anderen Formen bereitgestellt werden kann. So kann die Energiequelle beispielsweise auch eine Strahlungsquelle (z. B. eine Mikrowellenquelle) oder eine Wärmequelle sein. Auch bei der Verwendung derartiger Energiequellen ist die Erzeugung eines pulsierenden Plasmas denkbar.

Weiterhin kann bei allen Ausgestaltungen der erfindungsgemäßen Vorrichtung ein Bewegungsmittel vorgesehen werden, das eine Relativbewegung zwischen den Plasmaaustrittsöffnungen und dem mindestens einen Werkstück erzeugt.

Somit sind zwischen dem Werkstück und den Plasmastrahlen unter anderem gleichförmige oder ungleichförmige lineare, rotatorische oder oszillierende Bewegungen ausführbar. Die beschriebenen Bewegungsarten können separat, aber auch überlagert ausgeführt werden. Es ist denkbar, verschiedene Bewegungsmuster über einen zeitlichen Verlauf vorzusehen, um bestimmte Bereiche einer Oberfläche einer gewünschten Plasmabehandlung zu unterziehen. Eine Relativbewegung zwischen Werkstück und Plasmastrahlen kann unterstützend auf die Homogenität der Behandlung wirken und die maximale Oberfläche, die mit dem erzeugten Plasma einer Plasmaquelle behandelt werden kann, weiter vergrößern. Es ist möglich die Relativbewegung plasma- und/oder werkstückseitig auszuführen. Hinsichtlich der praktischen Ausführung des Bewegungsmittels sind unter anderem sämtliche Vorrichtungen denkbar, die z. B. bei Werkzeugmaschinen der gesteuerten oder geregelten Werkzeug- oder Werkstückbewegung dienen.

Das erfindungsgemäße Verfahren zur Plasmabehandlung von Oberflächen von mindestens einem Werkstück zeichnet sich dadurch aus, dass mittels einer Absaugung eine Druckdifferenz zwischen mindestens einer Plasmaquelle und einem abgeschlossenen Raum aufrechterhalten wird. In der mindestens einen Plasmaquelle wird ein Plasma erzeugt, welches in den abgeschlossenen Raum zugeführt und mithilfe eines Plasmaverteilungselements, das je einer Plasmaquelle in Strömungsrichtung nachgeordnet ist, in mehrere Plasmastrahlen aufgeteilt wird. Die Plasmastrahlen werden über eine Vielzahl von Plasmaaustrittsöffnungen des mindestens einen Plasmaverteilungselements auf mindestens eine Oberfläche des mindestens einen Werkstücks gerichtet zugeführt.

Bei einem beispielhaften Ablauf des erfindungsgemäßen Verfahrens wird das Werkstück, dessen Oberflächen behandelt werden sollen, in den abgeschlossenen Raum eingebracht oder ist bildet selbst den abgeschlossenen Raum teilweise oder vollständig. Durch die Absaugung, durch eine in dem abgeschlossenen Raum als Düse ausgebildete Öffnung und durch eine Regelung einer Gaszufuhr in die Plasmaquelle wird eine Druckdifferenz zwischen mindestens einer Plasmaquelle und einem abgeschlossenen Raum erzeugt und/oder aufrechterhalten. In dem abgeschlossenen Raum wird z. B. ein Grobvakuum ausgebildet. In der mindestens einen Plasmaquelle wird ein Plasma erzeugt, welches in den abgeschlossenen Raum zugeführt und mithilfe eines Plasmaverteilungselements, das je einer Plasmaquelle in Strömungsrichtung nachgeordnet ist, in mehrere Plasmastrahlen aufgeteilt, die sich hinsichtlich Intensität, Form, Richtung, Öffnungswinkel, Volumen, Abstand zur Werkstückoberfläche gleichen oder unterscheiden können. Die Plasmastrahlen werden über eine Vielzahl von Plasmaaustrittsöffnungen des mindestens einen Plasmaverteilungselements auf mindestens eine Oberfläche des mindestens einen Werkstücks direkt gerichtet zugeführt. Durch eine gepulste Gleichstromquelle wird ein pulsierendes Plasma in der Plasmaquelle erzeugt. Zwischen den Plasmaaustrittsöffnungen des mindestens einen Plasmaverteilungselements und damit den Plasmastrahlen und dem mindestens einen Werkstück wird eine Relativbewegung ausgeführt, die im zeitlichen Verlauf der Plasmabehandlung hinsichtlich der Bewegungsform und/oder der Bewegungsgeschwindigkeit variiert werden kann. Es sind sämtliche Bewegungsformen auch überlagert durchführbar.

Nachfolgend sind erfindungsgemäße Ausführungsformen der Vorrichtung und des Verfahrens zur Plasmabehandlung von Oberflächen anhand der beigefügten Zeichnungen näher beschrieben. Diese beispielhaft konkretisierten Ausführungsformen sind nicht als Einschränkungen für den Umfang der Erfindung zu werten.

Es zeigen:
- **Figur 1**: eine schematische Schnittansicht einer Ausführungsform der erfindungsgemäßen Vorrichtung zur Plasmabehandlung von Oberflächen;
- **Figur 2**: eine schematische Schnittansicht einer Ausführungsform der Vorrichtung zur Plasmabehandlung von Oberflächen mit einem fraktalen Plasmaverteilungselement;
- **Figur 3**: eine schematische Schnittansicht einer Ausführungsform der Vorrichtung zur Plasmabehandlung von Oberflächen, wobei Plasmaverteilungselemente, jeweils einer Ober- und einer Unterseite eines flächigen Werkstücks gegenüberliegen;
- **Figur 4**: eine schematische Schnittansicht einer Ausführungsform der Vorrichtung zur Plasmabehandlung von Oberflächen; wobei Plasmaaustrittsöffnungen eines Plasmaverteilungselements um einen Umfang eines Werkstücks verteilt sind;
- **Figur 5**: eine schematische Schnittansicht einer Ausführungsform der Vorrichtung zur Plasmabehandlung von Oberflächen, wobei ein abgeschlossener Raum durch ein Werkstück selbst, einen Versorgungs- und einen Absaugstutzen definiert ist.

In den Zeichnungen werden für gleiche oder gleich wirkende Elemente der Erfindung identische Bezugszeichen verwendet.

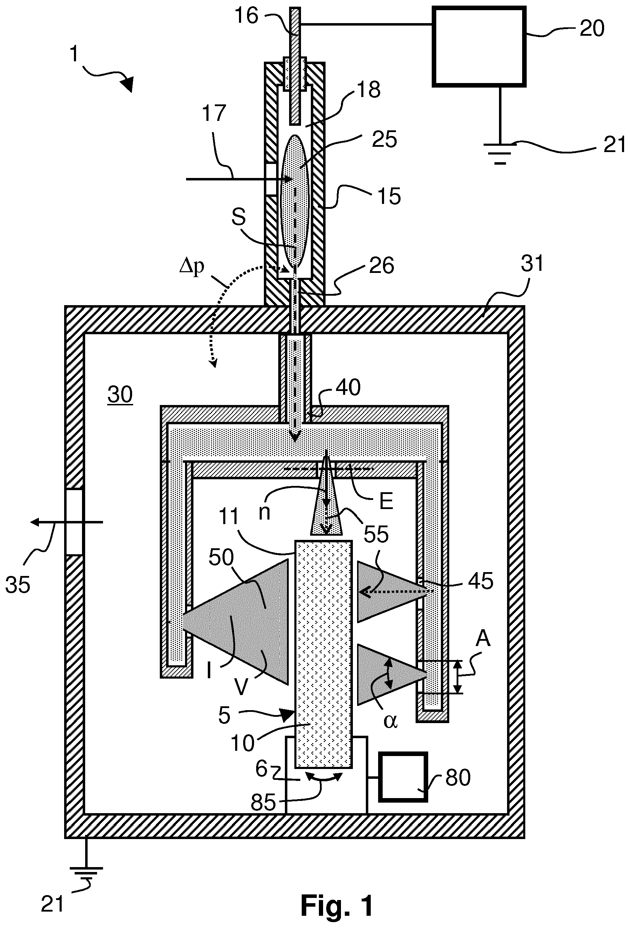

**Figur 1** zeigt eine erfindungsgemäße Vorrichtung 1 zur Plasmabehandlung von Oberflächen 5. In einem abgeschlossenen Raum 30 ist ein zu behandelndes Werkstück 10 mithilfe einer Werkstückaufnahme 6 angeordnet. Der abgeschlossene Raum 30 ist im Wesentlichen durch eine Prozesskammer 31 begrenzt. Durch eine Absaugung 35 ist in dem abgeschlossenen Raum 30 gegenüber einem Entladungsraum 18 einer Plasmaquelle 15 eine Druckdifferenz Δp einstellbar. Die Plasmaquelle 15 ist außerhalb des abgeschlossenen Raums 30, angeordnet, kann aber auch innerhalb des abgeschlossenen Raums 30 angeordnet werden. Über eine Gaszuführung 17 erfolgt eine Zuführung von Plasmagas in den Entladungsraum 18 der Plasmaquelle 15. An eine Elektrode 16 kann durch eine an ein Massenpotential 21 gelegte Energiequelle 20 eine Spannung angelegt werden. Die Energiequelle ist in der gezeigten Ausführungsform eine gepulste Gleichstromquelle 20. Zur Vermeidung von elektrostatischen Aufladungen und parasitären Stromfluss liegen die Plasmaquelle 15, die Prozesskammer 31 und die Energiequelle 20 gemeinsam am Massenpotential 21. Der abgeschlossene Raum 30 steht über eine Öffnung 26 mit der Plasmaquelle 15 in fluider Verbindung. Die Öffnung 26 ist als Düse oder Ventil ausgebildet, um den Durchfluss des Plasmas 25 in Strömungsrichtung S und die Druckdifferenz Δp zu regeln. In Strömungsrichtung S ist der Plasmaquelle 15 ein Plasmaverteilungselement 40, das eine Vielzahl von Plasmaaustrittsöffnungen 45 aufweist, nachgeordnet. Das Plasmaverteilungselement 40 ist derart ausgebildet, dass ein Normalenvektor n einer Ebene E einer jeden Plasmaaustrittsöffnung 45 auf eine zu behandelnde Oberfläche 5 des Werkstücks 10 gerichtet ist. Der Normalenvektor n der Ebene E der jeweiligen Plasmaaustrittsöffnung 45 definiert eine Richtung 55 eines jeden Plasmastrahls 50. Es ist ersichtlich, dass die Plasmaaustrittsöffnungen 45 und damit die Richtung 55 der Plasmastrahlen 50 ungleichmäßig um eine Außenkontur 11 des Werkstücks 10 verteilt sind. Das Plasmaverteilungselement 40 weist in dieser Ausführungsform Plasmaaustrittsöffnungen 45 mit unterschiedlichem Querschnitt A auf, woraus Plasmastrahlen 50 mit unterschiedlichem Öffnungswinkel α resultieren. Auch die Intensität I und das Volumen V eines jeden Plasmastrahls 50 kann mitunter durch den Querschnitt A der Plasmaaustrittsöffnungen 45 gesteuert werden.

Durch ein Bewegungsmittel 80 wird die Werkstückaufnahme 6, die das Werkstück 10 haltert, bewegt, wodurch eine Relativbewegung 85 zwischen dem Werkstück 10 und den Plasmastrahlen 50 erreicht wird.

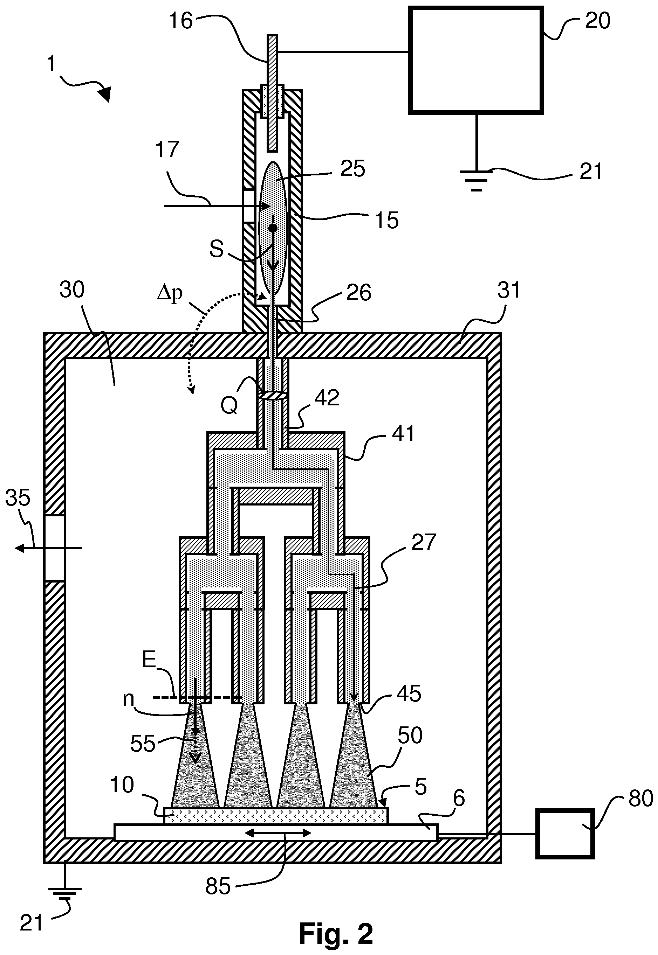

**Figur 2** zeigt eine erfindungsgemäße Vorrichtung 1 zur Plasmabehandlung von Oberflächen 5 mit einem fraktalen Plasmaverteilungselement 41, das aus mehreren Rohrstücken 42 gleichen Querschnitts Q aufgebaut ist. In einem abgeschlossenen Raum 30 ist ein zu behandelndes Werkstück 10 mithilfe einer Werkstückaufnahme 6 angeordnet. Der abgeschlossene Raum 30 ist im Wesentlichen durch eine Prozesskammer 31 begrenzt. Durch eine Absaugung 35 ist in dem abgeschlossenen Raum 30 gegenüber einem Entladungsraum 18 einer Plasmaquelle 15 eine Druckdifferenz Δp einstellbar. Die Plasmaquelle 15 ist außerhalb des abgeschlossenen Raums 30 angeordnet, kann aber auch innerhalb des abgeschlossenen Raums 30 angeordnet werden. Über eine Gaszuführung 17 erfolgt eine Zuführung von Plasmagas in den Entladungsraum 18 der Plasmaquelle 15. An eine Elektrode 16 kann durch eine an ein Massenpotential 21 gelegte Energiequelle 20 eine Spannung angelegt werden. Die Energiequelle ist in der gezeigten Ausführungsform eine gepulste Gleichstromquelle 20. Zur Vermeidung von elektrostatischen Aufladungen und parasitären Stromfluss liegen die Plasmaquelle 15, die Prozesskammer 31 und die Energiequelle 20 gemeinsam am Massenpotential 21. Der abgeschlossene 30 steht über eine Öffnung 26 mit der Plasmaquelle 15 in fluider Verbindung. Die Öffnung 26 ist als Düse ausgebildet, um den Durchfluss des Plasmas 25 in Strömungsrichtung S und die Druckdifferenz Δp zu regeln. In Strömungsrichtung S ist der Plasmaquelle 15 ein fraktales Plasmaverteilungselement 41, das eine Vielzahl von Plasmaaustrittsöffnungen 45 aufweist nachgeordnet. Das fraktale Plasmaverteilungselement 41 ist derart ausgebildet, dass ein Normalenvektor n einer Ebene E einer jeden Plasmaaustrittsöffnung 45 auf eine zu behandelnde Oberfläche 5 des Werkstücks 10 gerichtet ist. Der Normalenvektor n der Ebene E der jeweiligen Plasmaaustrittsöffnung 45 definiert eine Richtung 55 eines Plasmastrahls 50. Das fraktale Plasmaverteilungselement 41 ist derart ausgestaltet, dass ein mittlerer zurückgelegter Weg 27 des Plasmas 25 von der Plasmaquelle 15 bis zur jeweiligen Plasmaaustrittsöffnung 45 des fraktalen Plasmaverteilungselements 41, in der das Plasma 25 zu identischen Plasmastrahlen 50 aufgeteilt wird, gleich lang ist. Durch ein Bewegungsmittel 80 wird eine Werkstückaufnahme 6, die das Werkstück 10 haltert, bewegt, wodurch eine Relativbewegung 85 zwischen dem Werkstück 10 und den Plasmastrahlen 50 erreicht wird.

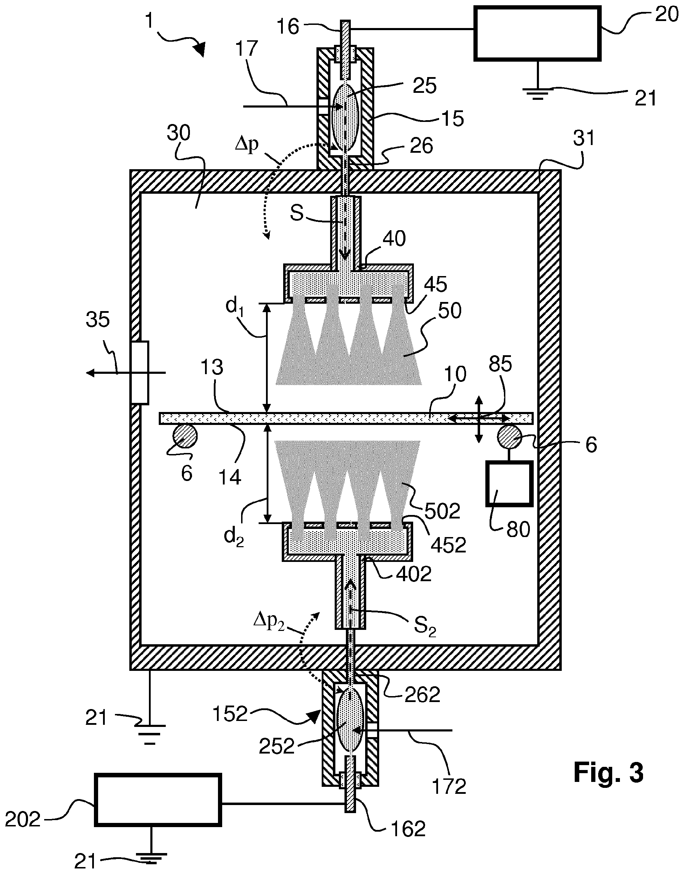

**Figur 3** zeigt eine erfindungsgemäße Vorrichtung 1 zur Plasmabehandlung von Oberflächen 5, wobei ein flächiges Werkstück 10 zwischen einem Plasmaverteilungselement 40 und einem Plasmaverteilungselement 402 in einem abgeschlossenen Raum 30 angeordnet ist. Das Plasmaverteilungselement 40 liegt einer Oberseite 13 des Werkstücks 10 gegenüber und das Plasmaverteilungselement 402 liegt einer Unterseite 14 des flächigen Werkstücks 10 gegenüber. Das Plasmaverteilungselement 40 teilt ein in einer Plasmaquelle 15 erzeugtes Plasma 25 in mehrere Plasmastrahlen 50 auf, die aus Plasmaaustrittsöffnungen 45 austreten und gerichtet der Oberseite 13 des Werkstücks 10 zugeführt werden. Das Plasmaverteilungselement 402 teilt ein in einer Plasmaquelle 152 erzeugtes Plasma 252 in mehrere Plasmastrahlen 502 auf, die aus Plasmaaustrittsöffnungen 452 austreten und gerichtet der Unterseite 14 des Werkstücks 10 zugeführt werden. Die Plasmaquelle 15 ist mit einer Energiequelle 20, welche auf ein Massenpotential 21 gelegt ist und einer Gaszuführung 17 verbunden. Die Energiequelle 20 ist ferner mit einer Elektrode 16 verbunden. Die Plasmaquelle 152 ist mit einer Energiequelle 202, welche ebenfalls auf ein Massenpotential 21 gelegt ist und einer Gaszuführung 172 verbunden. Die Energiequelle 202 ist ferner mit einer Elektrode 162 verbunden. Der abgeschlossene Raum 30 ist im Wesentlichen durch eine Prozesskammer 31 begrenzt. Durch eine Absaugung 35 und durch die Gaszuführungen 17, 172 sind in dem abgeschlossenen Raum 30 gegenüber den Plasmaquellen, 15, 152 Druckdifferenzen Δp und Δp₂ einstellbar. Die Plasmaquellen 15, 152 sind außerhalb des abgeschlossenen Raums 30, angeordnet, können aber auch innerhalb des abgeschlossenen Raums 30 angeordnet werden. Die Energiequellen in der gezeigten Ausführungsform sind gepulste Gleichstromquellen 20, 202. Zur Vermeidung von elektrostatischen Aufladungen und parasitären Stromfluss liegen die Plasmaquellen 15, 152, die Prozesskammer 31 und die Energiequellen 20, 202 gemeinsam am Massenpotential 21. Der abgeschlossene Raum 30 steht über Öffnungen 26, 262 mit den Plasmaquellen 15, 152 in fluider Verbindung. Die Öffnungen 26, 262 sind als Düsen ausgebildet um den Durchfluss der Plasmen 25, 252 in die Strömungsrichtung S bzw. S₂ und die Druckdifferenzen Δp bzw. Δp₂ zu regeln. Die Plasmaaustrittsöffnungen 45 des mindestens einen Plasmaverteilungselements 40, das der Oberseite 13 des Werkstücks 10 gegenüberliegt, weisen einen Abstand d₁ zur Oberseite 13 des Werkstücks 10 auf. Die Plasmaaustrittsöffnungen 452 des mindestens einen Plasmaverteilungselements 402, das der Unterseite 14 des Werkstücks 10 gegenüberliegt weisen einen Abstand d₂ zur Unterseite 14 des Werkstücks 10, auf. Durch ein Bewegungsmittel 80 wird eine Werkstückaufnahme, die als Rollenvorrichtung 6 ausgebildet ist, bewegt, wodurch eine Relativbewegung 85 zwischen dem Werkstück 10 und den Plasmastrahlen 50, 502 erreicht wird.

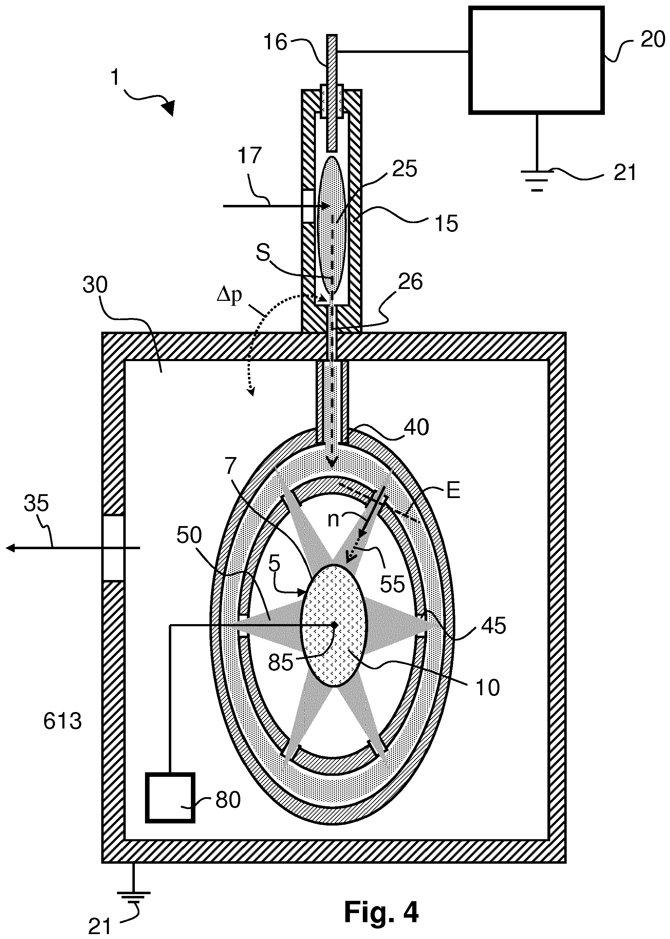

**Figur 4** zeigt eine erfindungsgemäße Vorrichtung 1 zur Plasmabehandlung von Oberflächen 5. In einem abgeschlossenen Raum 30 ist ein zu behandelndes, als ovalen Rundkörper ausgebildetes Werkstück 10 mithilfe einer Werkstückaufnahme (in Fig. 4 nicht sichtbar) angeordnet. Der abgeschlossene Raum 30 ist im Wesentlichen durch eine Prozesskammer 31 begrenzt. Durch eine Absaugung 35 ist in dem abgeschlossenen Raum 30 gegenüber einer Plasmaquelle 15 eine Druckdifferenz Δp einstellbar. Die Plasmaquelle 15 ist hier außerhalb des abgeschlossenen Raums 30 angeordnet. Über eine Gaszuführung 17 erfolgt eine Zuführung von Plasmagas in die Plasmaquelle 15. An eine Elektrode 16 kann durch eine an ein Massenpotential 21 gelegte Energiequelle 20 eine Spannung angelegt werden. Die Energiequelle 20 ist in der gezeigten Ausführungsform eine gepulste Gleichstromquelle 20. Zur Vermeidung von elektrostatischen Aufladungen und parasitären Stromfluss liegen die Plasmaquelle 15, die Prozesskammer 31 und die Energiequelle 20 gemeinsam am Massenpotential 21. Der abgeschlossene Raum 30 steht über eine Öffnung 26 mit der Plasmaquelle 15 in fluider Verbindung. Die Öffnung 26 kann z. B. als Düse oder Ventil ausgebildet sein, um den Durchfluss des Plasmas 25 in Strömungsrichtung S und die Druckdifferenz Δp zu regeln. In Strömungsrichtung S ist der Plasmaquelle 15 ein Plasmaverteilungselement 40, das eine Vielzahl von Plasmaaustrittsöffnungen 45 aufweist, nachgeordnet. Das Plasmaverteilungselement 40 ist derart ausgebildet, dass ein Normalenvektor n einer Ebene E einer jeden Plasmaaustrittsöffnung 45 auf eine zu behandelnde Oberfläche 5 des Werkstücks 10 gerichtet ist. Der Normalenvektor n der Ebene E der jeweiligen Plasmaaustrittsöffnung 45 definiert eine Richtung 55 eines jeden Plasmastrahls 50. Die Plasmaaustrittsöffnungen 45 des Plasmaverteilungselements 40 sind homogen um einen Umfang 7 der zu behandelnden Oberfläche 5 des Werkstücks 10 verteilt. Die Plasmaaustrittsöffnungen 45 sind gemäß der zu behandelnden Oberfläche 5 so verteilt, dass die Plasmastrahlen 50 den Umfang 7 des Werkstücks 10 gleichmäßig erfassen. Es erfolgt also eine besonders homogene Behandlung der Oberfläche 5 des Werkstücks 10. Durch ein Bewegungsmittel 80 wird zwischen dem Werkstück 10 und den Plasmastrahlen 50 eine Relativbewegung 85 ausgeführt. Die Relativbewegung erfolgt senkrecht zur Oberfläche der Figur.

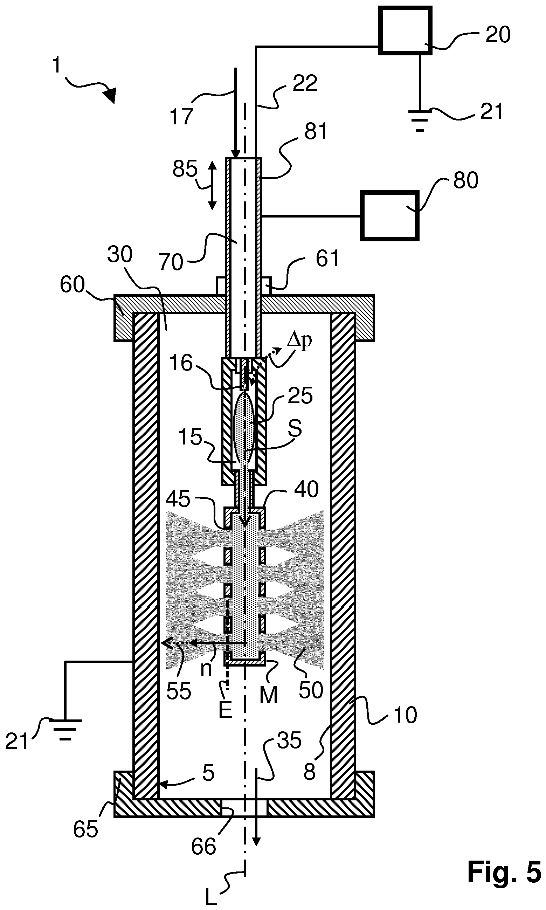

**Figur 5** zeigt eine schematische Schnittansicht einer weiteren Ausführungsform der Vorrichtung zur Plasmabehandlung von Oberflächen. Bei dieser besonders vorteilhaften Ausgestaltung der erfindungsgemäßen Vorrichtung 1 ist der abgeschlossene Raum 30 durch das als Rohr 10 ausgebildete Werkstück selbst, einen Versorgungsflansch 60 und einen Absaugflansch 65 definiert. Durch eine Absaugung 35 ist in dem abgeschlossenen Raum 30 gegenüber einer Plasmaquelle 15 eine Druckdifferenz Δp einstellbar. An eine Elektrode 16 kann durch eine an ein Massenpotential 21 gelegte Energiequelle 20 eine Spannung angelegt werden. Die Energiequelle ist in der gezeigten Ausführungsform eine gepulste Gleichstromquelle 20. Die Plasmaquelle 15, das Werkstück 10 und die Energiequelle 20 liegen gemeinsam am Massenpotential 21. Durch den Versorgungsflansch 60 ragt eine Versorgungsleitung 70, die eine Gaszuführung 17 und eine Energiezuführung 22 aufnimmt. Die Versorgungsleitung 70 ragt in den abgeschlossenen Raum 30. Am freien Ende der Versorgungsleitung 70 sitzt eine Plasmaquelle 15 und ein Plasmaverteilungselement 40. Wie bei allen Ausführungsformen der erfindungsgemäßen Vorrichtung 1 ist das Plasmaverteilungselement 40 derart ausgebildet, dass ein Normalenvektor n einer Ebene E einer jeden Plasmaaustrittsöffnung 45 auf eine zu behandelnde Oberfläche 5 des Werkstücks 10 gerichtet ist. Der Normalenvektor n der Ebene E der jeweiligen Plasmaaustrittsöffnung 45 definiert eine Richtung 55 eines jeden Plasmastrahls 50. Das Plasmaverteilungselement 40 ist als Hohlkörper ausgebildet und die Plasmaaustrittsöffnungen 45 sind homogen über eine Mantelfläche M des Plasmaverteilungselements 40 in Bezug auf eine Innenfläche 8 des Werkstücks 10 verteilt, so dass die Plasmastrahlen 50 homogen über die Innenfläche 8 des Werkstücks 10 verteilt sind. Dadurch erfolgt eine besonders homogene Behandlung der Innenfläche 8 des Werkstücks 10. Der abgeschlossene Raum 30 steht über den Absaugflansch 65 mit der Absaugung 35 in fluider Verbindung. In dieser Ausführungsform ist zur Aufrechterhaltung der Druckdifferenz Δp ein Dichtelement 66 in den Absaugflansch 65 eingearbeitet. Die Funktion der Abdichtung zur Versorgungsseite übernimmt hierbei eine Durchführung 61. Alternativ könnte ein Dichtelement 66 auch in den Versorgungsflansch 60 eingearbeitet sein und eine Durchführung 61 auch auf der Absaugseite vorgesehen werden. Durch ein Bewegungsmittel 80 wird zwischen dem Werkstück 10 und den Plasmastrahlen 50 eine Relativbewegung 85 ausgeführt. Die Relativbewegung 85 erfolgt parallel zur Längsachse L des Werkstücks 10 und wird über eine Transferstange 81 vom Bewegungsmittel 80 auf die Plasmaquelle 15 übertragen. Die Transferstange 81 ist derart ausgebildet, dass die Versorgungsleitung 70 durch die Transferstange 81 hindurchgeführt wird.

**Bezugszeichenliste**

| | |
|---|---|
| 1 | Vorrichtung zur Plasmabehandlung |
| 5 | Oberfläche eines Werkstücks |
| 6 | Werkstückaufnahme |
| 7 | Umfang eines Werkstücks |
| 8 | Innenfläche eines Werkstücks |
| 10 | Werkstück |
| 11 | Außenkontur eines Werkstücks |
| 13 | Oberseite eines flächigen Werkstücks |
| 14 | Unterseite eines flächigen Werkstücks |
| 15 | Plasmaquelle |
| 152 | Plasmaquelle |
| 16 | Elektrode |
| 162 | Elektrode |
| 17 | Gaszuführung |
| 18 | Entladungsraum |
| 20 | Energiequelle |
| 202 | Energiequelle |
| 21 | Massenpotential |
| 22 | Energiezuführung |
| 25 | Plasma |
| 252 | Plasma |
| 26 | Öffnung |
| 262 | Öffnung |
| 27 | Mittlere zurückgelegte Strecke des Plasmas |
| 30 | Abgeschlossener Raum |
| 31 | Prozesskammer |
| 35 | Absaugung |
| 40 | Plasmaverteilungselement |
| 402 | Plasmaverteilungselement |
| 41 | Fraktales Plasmaverteilungselement |
| 42 | Rohrstück |
| 45 | Plasmaaustrittsöffnung eines Plasmaverteilungselements |
| 452 | Plasmaaustrittsöffnung eines Plasmaverteilungselements |
| 50 | Plasmastrahl |
| 502 | Plasmastrahl |
| 55 | Richtung eines Plasmastrahls |
| 60 | Versorgungsflansch |
| 61 | Durchführung |
| 65 | Absaugflansch |
| 66 | Dichtelement |
| 70 | Versorgungsleitung |
| 75 | Innenfläche eines als Hohlkörper ausgebildeten Werkstück |
| 80 | Bewegungsmittel |
| 81 | Transferstange |
| 85 | Relativbewegung |
| Δp | Druckdifferenz zwischen Plasmaquelle und abgeschlossenem Raum |
| Δp₂ | Druckdifferenz zwischen Plasmaquelle und abgeschlossenem Raum |
| S | Strömungsrichtung eines Plasmas |
| S₂ | Strömungsrichtung eines Plasmas |
| n | Normalenvektor einer Ebene einer Plasmaaustrittsöffnung |
| E | Ebene einer Plasmaaustrittsöffnung |
| A | Querschnitt einer Plasmaaustrittsöffnung |
| α | Öffnungswinkel eines Plasmastrahls |
| d₁ | Abstand der Plasmaaustrittsöffnungen zur Werkstückoberfläche |
| d₂ | Abstand der Plasmaaustrittsöffnungen zur Werkstückoberfläche |
| Q | Querschnitt eines Rohrstücks |
| M | Mantelfläche eines Plasmaverteilungselements |
| L | Längsachse eines Werkstücks |

## Patentansprüche

1. Vorrichtung (1) zur Plasmabehandlung von Oberflächen (5) von mindestens einem Werkstück (10), umfassend
• mindestens eine Plasmaquelle (15), die mit einer Energiequelle (20) zur Erzeugung eines Plasmas (25) verbunden ist;
• einen abgeschlossenen Raum (30);
• mindestens eine Absaugung (35) zur Einstellung einer Druckdifferenz (Δp) zwischen der mindestens einen Plasmaquelle (15) und dem abgeschlossenen Raum (30);
wobei
• jede Plasmaquelle (15) über eine einzige Öffnung (26) mit einem jeweiligen Plasmaverteilungselement (40), das innerhalb des abgeschlossenen Raumes (30) angeordnet ist, in fluider Verbindung steht;
und
• jedes Plasmaverteilungselement (40) eine Vielzahl von Plasmaaustrittsöffnungen (45) aufweist; **dadurch gekennzeichnet dass**
die Öffnung (26) der mindestens einen Plasmaquelle (15) als regelbare Düse oder regelbares Ventil ausgebildet ist.

2. Vorrichtung nach Anspruch 1, wobei das mindestens eine Plasmaverteilungselement (40) derart ausgebildet ist, dass ein Normalenvektor (n) einer Ebene (E) einer jeden Plasmaaustrittsöffnung (45) auf eine zu behandelnde Oberfläche (5) des mindestens einen Werkstücks (10) gerichtet ist und wobei der Normalenvektor (n) der Ebene (E) der jeweiligen Plasmaaustrittsöffnung eine Richtung (55) eines Plasmastrahls (50) definiert.

3. Vorrichtung nach einem der Ansprüche 1 oder 2, wobei das mindestens eine Plasmaverteilungselement (40) als fraktales Plasmaverteilungselement (41) ausgebildet ist.

4. Vorrichtung nach einem der Ansprüche 1 oder 2, wobei das mindestens eine Plasmaverteilungselement (40) derart ausgestaltet ist, dass Plasmaaustrittsöffnungen (45) einer Oberseite (13) und einer Unterseite (14) eines flächigen Werkstücks (12) gegenüberliegen.

5. Vorrichtung nach Anspruch 4, wobei der abgeschlossene Raum (30) an gegenüberliegenden Begrenzungen mit jeweils mindestens einer Plasmaquelle (15, 152) versehen ist, denen jeweils ein Plasmaverteilungselement (40, 402) zugeordnet ist, so dass die Plasmaaustrittsöffnungen (45, 452) des jeweiligen Plasmaverteilungselements (40, 402) der Oberseite (13) bzw. der Unterseite (14) des flächigen Werkstücks (10) gegenüberliegen.

6. Vorrichtung nach einem der Ansprüche 1 oder 2, wobei die Plasmaaustrittsöffnungen (45) des mindestens einen Plasmaverteilungselements (40) homogen um einen Umfang (7) der zu behandelnden Oberfläche (5) des Werkstücks (10) verteilt sind.

7. Vorrichtung nach einem der Ansprüche 1 oder 2, wobei das mindestens eine Plasmaverteilungselement (40) als Hohlkörper ausgebildet ist und die Plasmaaustrittsöffnungen (45) homogen über eine Mantelfläche (M) des mindestens einen Plasmaverteilungselements (40) verteilt sind.

8. Vorrichtung nach Anspruch 7, wobei der abgeschlossene Raum (30) durch das als Hohlkörper ausgebildete Werkstück (10) selbst, einen Versorgungsflansch (60) und einen Absaugflansch (65) definiert ist, und wobei durch den Versorgungsflansch (60) mindestens eine Versorgungsleitung (70) in den abgeschlossenen Raum (30) ragt, an deren freien Ende die mindestens eine Plasmaquelle (15) und das mindestens eine Plasmaverteilungselement (40) sitzt, und wobei der abgeschlossene Raum (15) über einen Absaugflansch (65) mit der Absaugung (35) in fluider Verbindung steht.

9. Vorrichtung nach einem der vorhergehenden Ansprüche, wobei die Energiequelle (20) eine gepulste Gleichstromquelle ist, so dass ein pulsierendes Plasma (25) erzeugbar ist.

10. Vorrichtung nach einem der vorhergehenden Ansprüche, wobei ein Bewegungsmittel (80) vorgesehen ist, das eine Relativbewegung (85) zwischen den Plasmaaustrittsöffnungen (45) und dem mindestens einen Werkstück (10) erzeugt.

11. Verfahren zur Plasmabehandlung von Oberflächen (5) von mindestens einem Werkstück (10), mit den folgenden Schritten:
• Aufrechterhalten einer Druckdifferenz (Δp) zwischen mindestens einer Plasmaquelle (15) und einem abgeschlossenen Raum (30) mittels einer Absaugung (35);
• Erzeugen eines Plasmas (25) in der mindestens einen Plasmaquelle (15);
• Zuführen des Plasmas (25) über je eine einzige Öffnung (26) der mindestens einen Plasmaquelle (25) in je ein im abgeschlossenen Raum (30) angeordnetes Plasmaverteilungselement (40), wobei über die jeweilige, als regelbare Düse oder regelbares Ventil ausgebildete Öffnung (26) der mindestens einen Plasmaquelle (15) die Druckdifferenz (Δp) zwischen der mindestens einer Plasmaquelle (15) und dem abgeschlossenen Raum (30) zusätzlich gesteuert wird;
• gerichtetes Zuführen mehrerer Plasmastrahlen (50) über eine Vielzahl von Plasmaaustrittsöffnungen (45) jedes Plasmaverteilungselements (40) auf mindestens eine Oberfläche (5) des mindestens einen Werkstücks (10).

12. Verfahren nach Anspruch 11, wobei das erzeugte Plasma (25) ein pulsierendes Plasma ist.

13. Verfahren nach einem der Ansprüche 11 bis 12, wobei zwischen den Plasmaaustrittsöffnungen (45) des mindestens einen Plasmaverteilungselements (40) und dem mindestens einen Werkstück (10) eine Relativbewegung (85) ausgeführt wird.

## Claims

1. An apparatus (1) for plasma treatment of surfaces (5) of at least one workpiece (10), comprising:
• at least one plasma source (15) connected to a power supply (20) for generating a plasma (25);
• an enclosed space (30);
• at least one extraction means (35) for setting a pressure difference (Δp) between the at least one plasma source (15) and the enclosed space (30); wherein
• via a single opening (26) each plasma source (15) is in fluid communication with a respective plasma distribution element (40) arranged within the enclosed space (30);
• each plasma distribution element (40) has a plurality of plasma discharge openings (45);
**characterized in that**
• the opening (26) of the at least one plasma source (15) is formed as an adjustable nozzle or adjustable valve.

2. The apparatus according to claim 1, wherein the at least one plasma distribution element (40) is configured such that a normal vector (n) of a plane (E) of each plasma discharge opening (45) is directed onto a surface (5) to be treated of the at least one workpiece (10), and wherein the normal vector (n) of the plane (E) of the respective plasma discharge opening defines a direction (55) of a plasma jet (50).

3. The apparatus according to anyone of the claims 1 or 2, wherein the at least one plasma distribution element (40) is formed as a fractal plasma distribution element (41).

4. The apparatus according to anyone of the claims 1 or 2, wherein the at least one plasma distribution element (40) is configured such that plasma discharge openings (45) face a top surface (13) and a bottom surface (14) of a planar workpiece (12).

5. The apparatus according to claim 4, wherein the enclosed space (30) has on opposite boundaries at least one plasma source (15, 152) each, which each have a plasma distribution element (40, 402) assigned to them, so that the plasma discharge openings (45, 452) of the respective plasma distribution element (40, 402) face the top surface (13) and the bottom surface (14) of the planar workpiece (10).

6. The apparatus according to one of the claims 1 or 2, wherein the plasma discharge openings (45) of the at least one plasma distribution element (40) are homogenously distributed around a circumference (7) of the surface (5) to be treated of the workpiece (10).

7. The apparatus according to anyone of the claims 1 or 2, wherein the at least one plasma distribution element (40) is formed as a hollow body, and the plasma discharge openings (45) are homogenously distributed over a lateral surface (M) of the at least one plasma distribution element (40).

8. The apparatus according to claim 7, wherein the enclosed space (30) is defined by the workpiece (10) itself, which is shaped as a hollow body, a supply flange (60) and an extraction flange (65) and wherein through the supply flange (60) at least one supply line (70) extends into the enclosed space (30), at the free end of which the at least one plasma source (15) and the at least one plasma distribution element (40) are located, and wherein the enclosed space (15) is in fluid communication with the extraction means (35) via an extraction flange (65).

9. The apparatus according to anyone of the preceding claims, wherein the energy source (20) is a pulsed DC power source, so that a pulsating plasma (25) can be generated.

10. The apparatus according to anyone of the preceding claims, wherein a movement means (80) is provided which generates a relative movement (85) between the plasma discharge openings (45) and the at least one workpiece (10).

11. A method for plasma treatment of surfaces (5) of at least one workpiece (10), comprising the following steps:
• maintaining a pressure difference (Ap) between at least one plasma source (15) and an enclosed space (30) by means of an extraction means (35);
• generating a plasma (25) in the at least one plasma source (15);
• supplying the plasma (25) via a respective single opening (26) of the at least one plasma source (25) into a respective plasma distribution element (40) disposed in the enclosed space (30), wherein the pressure difference (Ap) between the at least one plasma source (15) and the enclosed space (30) is additionally controlled via the respective opening (26), which is formed as an adjustable nozzle or adjustable valve, of the at least one plasma source (15);
• focused directing of several plasma jets (50) via a plurality of plasma discharge openings (45) of each plasma distribution element (40) onto at least one surface (5) of the at least one workpiece (10).

12. The method according to claim 11, wherein the generated plasma (25) is a pulsating plasma.

13. The method according to anyone of the claims 11 to 12, wherein a relative movement (85) is performed between the plasma discharge openings (45) of the at least one plasma distribution element (40) and the at least one workpiece (10).

## Revendications

1. Dispositif (1) de traitement de plasma de surfaces (5) d'au moins une pièce à usiner (10), comprenant
• au moins une source de plasma (15) qui est reliée à une source d'énergie (20) pour générer un plasma (25);
• une pièce fermée (30);
• au moins une aspiration (35) pour régler une différence de pression (ΔP) entre la source plasma (15) et la pièce fermée (30);
• chaque source de plasma (15) étant en connexion fluide au-dessus d'une seule ouverture (26) avec un élément de distribution de plasma (40) qui est disposé dans une pièce fermée (30);
• chaque élément de distribution de plasma (40) présentant une pluralité d'ouvertures de sortie de plasma (45);
**caractérisé en cela que**
l'ouverture (26) de la source de plasma (15) étant formée en tant que buse réglable ou vanne réglable.

2. Dispositif selon la revendication 1, au moins un élément de distribution de plasma (40) étant formé de sorte à ce qu'un vecteur normal (n) d'un niveau (E) de chaque ouverture de sortie de plasma (45) soit orienté sur une surface à traiter (5) de la pièce à usiner (10) et le vecteur normal (n) du niveau (E) de l'ouverture de sortie de plasma définissant une direction (55) d'un jet de plasma (50).

3. Dispositif selon l'une des revendications 1 ou 2, l'élément de distribution de plasma (40) étant formé comme un élément fractal de distribution de plasma (41).

4. Dispositif selon l'une des revendications 1 ou 2, l'élément de distribution de plasma (40) étant arrangé de sorte à ce que les ouvertures de sortie de plasma (45) fassent face à une partie supérieure (13) et à une partie inférieure (14) d'une grande pièce à usiner.

5. Dispositif selon la revendication 4, la pièce fermée (30) étant pourvue sur les limites se faisant face d'au moins une source de plasma (15, 152) sur lesquelles est situé respectivement un élément de distribution de plasma (45, 452) de l'élément de distribution de plasma respectif (40, 402) de la partie supérieure (13) et de la partie inférieure (14) de la pièce à usiner (10) plane.

6. Dispositif selon l'une des revendications 1 ou 2, les ouvertures de sortie de plasma (45) de l'au moins un élément de distribution de plasma (40) étant réparties de manière homogène sur une périphérie (7) de la surface à traiter (5) de la pièce à usiner (10).

7. Dispositif selon l'une des revendications 1 ou 2, l'au moins un élément de distribution de plasma (40) étant formé comme un corps creux et les ouvertures de sortie de plasma (45) étant répartie de manière homogène au-dessus d'une surface de manteau (M) de l'au moins un élément de répartition de plasma.

8. Dispositif selon la revendication 7, la pièce fermée (30) étant définie par la pièce à usiner (10) elle-même formée comme un corps creux, par une bride d'alimentation (60) et une bride d'aspiration (65), et par la bride d'alimentation (60) au moins un conduite d'alimentation (70) sortant en saillie dans la pièce fermée (30), la source de plasma (15) et l'élément de distribution de plasma (40) étant placés sur son extrémité libre et, la pièce fermée (15) étant en connexion fluide via une bride d'aspiration (65) avec l'aspiration (35).

9. Dispositif selon l'une des revendications précédentes, la source d'énergie (20) étant une source de courant continu à pulsation si bien qu'un plasma pulsant (25) peut être généré.

10. Dispositif selon l'une des revendications précédentes, un moyen de mouvement (80) étant prévu qui génère un mouvement relatif (85) entre les ouvertures de sortie de plasma (45) et la pièce à usiner (10).

11. Procédé de traitement de plasma de surfaces (5) d'au moins une pièce à usiner (10), avec les étapes suivantes:
• maintien d'une différence de pression (ΔP) entre au moins une source de plasma (15) et une pièce fermée (30) avec une aspiration (35);
• génération d'un plasma (25) dans l'au moins une source de plasma (15);
• alimentation du plasma (25) au-dessus respectivement d'une seule ouverture (26) de l'au moins une source de plasma (25) dans respectivement un élément de distribution de plasma (40) situé dans une pièce fermée (30), via l'ouverture (26) formée comme buse réglable ou vanne réglable de l'au moins une source de plasma (15) la différence de pression (ΔP) étant commandée entre l'au moins une source de plasma (15) et la pièce fermée (30) en plus;
• alimentation dirigée de plusieurs jets de plasma (50) via une pluralité d'ouvertures de sortie de plasma (45) de chaque élément de distribution de plasma (40) sur au moins une surface (5) de l'au moins une pièce à usiner (10).

12. Procédé selon la revendication 11, le plasma généré (25) étant un plasma pulsant.

13. Procédé selon l'une des revendications 11 ou 12, entre les ouvertures de sortie de plasma (45) de l'au moins un élément de distribution de plasma (40) et l'au moins une pièce à usiner (10) un mouvement relatif (85) étant exécuté.
